# EUROPÄISCHE PATENTSCHRIFT

(11) **EP 1 576 865 B1**
(45) Veröffentlichungstag und Bekanntmachung des Hinweises auf die Patenterteilung: **09.07.2008**
(21) Anmeldenummer: 03795840.2
(22) Anmeldetag: 22.11.2003
(51) Int. Cl.: H05K 5/00

(54) **ELEKTROGERÄTEGEHÄUSE**
ELECTRICAL APPLIANCE HOUSING
LOGEMENT POUR APPAREIL ELECTRIQUE

(30) Priorität: 21.12.2002 DE 10260428
(43) Veröffentlichungstag der Anmeldung: 21.09.2005
(73) Patentinhaber: Braun GmbH, 61476 Kronberg (DE)
(72) Erfinder: HERZOG, Karl, 60489 Frankfurt (DE); FRITSCH, Thomas, 65817 Eppstein (DE)
(86) Internationale Anmeldenummer: PCT/EP2003/013154
(87) Internationale Veröffentlichungsnummer: WO 2004/057936

(56) Entgegenhaltungen:
- EP-A- 0 684 020
- EP-A- 0 692 215
- US-A- 6 093 900

## Beschreibung

Die vorliegende Erfindung betrifft ein Gehäuse, z. B. ein Elektrogerätegehäuse oder sonstiges, gegebenenfalls wasserdichtes Gehäuse mit einem Gehäusekorpus aus Hartkunststoff, in dem eine Öffnung zur Betätigung eines Schalters oder dergleichen im Inneren des Gehäusekorpus vorgesehen ist, wobei die Öffnung mit einer Membran aus Weichkunststoff verschlossen ist und ein Betätigungsknopf zur Betätigung des Schalters auf der bzw. in der Membran vorgesehen ist.

Elektrische Zahnbürsten oder andere Elektrokleingeräte wie Rasierapparate, Küchenmaschinen und dergleichen haben in der Regel ein wasserdichtes Gehäuse, innerhalb dessen oftmals Schalter angeordnet sind, so dass die Betätigungsenergie für solche Schalter derart durch die Gehäusewand geleitet werden muss, dass kein Wasser eindringen kann. Bei einer üblichen Anordnung liegt der entsprechende Schalter bzw. die zu betätigende Bremse oder Kupplung oder das zu betätigende Ventil oder Getriebe etc. hinter einer Öffnung der Gehäusewand, die durch eine elastische Membran verschlossen ist. Zum Schalten des Geräts drückt der Benutzer mit einem Finger auf die Membran und betätigt so den darunterliegenden Schalter. Die Membran besteht aus einem weichen Kunststoff und ist mit der aus hartem Kunststoff bestehenden Gehäusewand stofflich verbunden, insbesondere im Zweikomponenten-Spritzverfahren spritzgegossen.

Solche Gerätegehäuse sind in der US-A- 6 093 900, in der EP 0 684 020 oder in der EP 0 692 215 offenbart.

Als optischen und taktilen Hinweis auf den darunterliegenden Schalter trägt die Membran oftmals außen eine Erhöhung oder eine andere räumliche Struktur. Ein Nachteil besteht bei dieser Konstruktion jedoch darin, dass die räumliche Struktur aus demselben Stoff wie die Membran besteht und somit dieselbe Farbe hat. Dies mindert die Erkennbarkeit.

Es wurde deshalb bereits bei bekannten Geräten vorgesehen, einen Betätigungsknopf aus Metall in ein durchgehendes Loch der Membran zu stecken. Hierbei ist jedoch nachteilig, dass Wasser durch das Loch in das Gehäuseinnere eindringen kann. Die Wasserdichtheit des Gehäuses ist nicht mehr gegeben.

Der vorliegenden Erfindung liegt daher die Aufgabe zugrunde, ein verbessertes Elektrogerätegehäuse der eingangs genannten Art zu schaffen, das Nachteile des Standes der Technik vermeidet und letzteren in vorteilhafter Weise weiterbildet. Insbesondere soll ein Betätigungsknopf so mit der Membran verbunden werden, dass kein Wasser die Gehäusewand durchdringen kann.

Erfindungsgemäß wird diese Aufgabe durch ein Elektrogerätegehäuse gemäß Patentanspruch 1 gelöst. Bevorzugte Ausgestaltungen der Erfindung sind Gegenstand der Unteransprüche.

Erfindungsgemäß ist der Betätigungsknopf an einem Sockel aus Hartkunststoff befestigt, der stofflich mit der Membran verbunden ist. Der Sockel aus Hartkunststoff ist mit der Membran hermetisch verbunden, so dass kein Wasser in das Gehäuseinnere eindringen kann, wobei vorzugsweise der Sockel und die Membran aus stofflich verwandten Kunststoffen bestehen, um eine gute Verbindung zu gewährleisten. Der Betätigungsknopf kann aus verschiedenen Materialien bestehen, ohne dass aus Gründen einer dichten Verbindung zur Membran auf eine geeignete Materialpaarung der Membran und des Betätigungsknopfs geachtet werden müsste. An den Sockel aus Hartkunststoff kann die Membran in einem Zweikomponenten-Spritzgussverfahren angespritzt werden.

In Weiterbildung der Erfindung ist der den Betätigungsknopf tragende Sockel über mindestens einen elastischen Steg mit dem Gehäusekorpus aus Hartkunststoff verbunden. Der elastische Steg ist vorzugsweise materialhomogen und einstückig mit dem Gehäusekorpus und/oder dem Sockel ausgebildet. Insbesondere können der Sockel, der zumindest eine Steg sowie der Gehäusekorpus einstückig aus Kunststoff, beispielsweise Polypropylen oder ABS, spritzgegossen sein. Der elastische Steg, über den der Sockel mit dem Gehäusekorpus verbunden ist, erleichtert nicht nur die Positionierung des Sockels in der Öffnung im Gehäusekorpus, wenn die elastische Membran angespritzt wird. Zusätzlich stützt der elastische Steg die Membran ab, was insbesondere bei großflächigen Membranen von Vorteil ist, die sonst zur Faltenbildung oder zu großer Nachgiebigkeit neigen.

Um eine absolute Wasserdichtheit des Gehäuses im Bereich des Betätigungsknopfs zu erreichen, ist der Sockel, auf dem der Betätigungsknopf sitzt, frei von Durchgangsausnehmungen ausgebildet. Der Betätigungsknopf durchdringt den Sockel zumindest nicht vollständig, so dass es keine durchgehende Öffnung von der Außenseite des Sockels zur Innenseite des Sockels gibt.

Die Membran kann den Sockel nicht nur an dessen Mantelfläche umschließen, sondern könnte grundsätzlich auch die Stirnseiten des Sockels zumindest teilweise überdecken, so dass der Sockel quasi in die Membran eingegossen wäre. Vorzugsweise jedoch ist zumindest die der Gehäuseaußenseite zugewandte Stirnseite des Sockels frei von einer Überdekkung durch die Membran ausgebildet. An der zur Gehäuseaußenseite schauenden Stirnseite des Sockels ist in der Membran eine Aussparung vorgesehen, die mehr oder weniger der Stirnseitenfläche des Sockels entspricht. Gemäß einer bevorzugten Ausgestaltung der Erfindung durchdringt der Sockel die Membran von deren Außenseite zu deren Innenseite, d.h. auch die zur Innenseite des Gehäuses schauende Stirnseite des Sockels ist von der Membran nicht überdeckt.

Der zuvor genannte zumindest eine elastische Steg, der den Sockel mit dem Gehäusekorpus verbindet, könnte grundsätzlich in die Membran eingegossen sein. Um ein ansprechendes Aussehen zu erzielen, liegt der zumindest eine elastische Steg jedenfalls nicht auf der Außenseite der Membran. Vorzugsweise liegt der Steg auf der Innenseite der Membran. Dies ist nicht nur aus optischen Gründen vorteilhaft, sondern bewirkt auch eine Abstützung der Membran, wenn diese mit einer Fingerkuppe eingedrückt wird.

Um eine gute optische und taktile Erkennbarkeit des Betätigungsknopfs zu erreichen, ist der Betätigungsknopf gegenüber der Membran erhaben ausgebildet.

Der Betätigungsknopf und der Sockel sind nach einer Ausführung der Erfindung vorzugsweise separate Bauteile und miteinander gefügt, so dass sie aus verschiedenen Materialien bestehen können. Während der Sockel vorzugsweise aus dem Material des Gehäusekorpus besteht, kann der Betätigungsknopf aus Metall, Keramik, Glas oder auch Kunststoff bestehen.

Der Betätigungsknopf und der Sockel können auf verschiedene Weise miteinander gefügt sein. Nach einer bevorzugten Ausführung der Erfindung besitzt der Sockel ein Sackloch, in dem der Betätigungsknopf mit einem schaftförmigen Abschnitt aufgenommen ist. Der schaftförmige Abschnitt kann in dem Sackloch verpresst, verklebt oder eingegossen sein. Um ein Herauslösen des Betätigungsknopfs bzw. des Schafts aus dem Sackloch zu verhindern, kann an dem Schaft mindestens eine radiale Rippe und/oder ein Wulst vorgesehen sein. Ein solcher radialer Vorsprung gräbt sich in die Wandung des Sacklochs im Sockel, so dass ein Herausziehen unmöglich wird.

Um eine dauerhafte Verbindung zwischen dem Betätigungsknopf und dem Sockel zu erreichen, kann der Betätigungsknopf mit dem Sockel auch verschweißt sein.

In alternativer Weiterbildung der Erfindung können der Betätigungsknopf und der Sockel auch materialhomogen einstückig ausgebildet sein. Der Sockel bildet hier gleichzeitig den Betätigungsknopf.

Insbesondere wenn der Betätigungsknopf nachträglich mit dem Sockel gefügt wird und über letzteren nach außen vorsteht, ist es wichtig, dass zwischen die Membran und den Betätigungsknopf kein Schmutz eindringen kann. Nach einer bevorzugten Ausführung der Erfindung ist deshalb vorgesehen, dass die Membran einen den Sockel umschließenden, über den Sockel zur Geräteaußenseite vorspringenden Randabschnitt aufweist, der passgenau oder vorzugsweise unter einer Presspassung an einem Randabschnitt des Betätigungsknopfs anliegt. Beim Fügen des Betätigungsknopfs mit dem Sockel wird der Randabschnitt der Membran verformt, so dass zwischen dem Betätigungsknopf und der Membran eine Presspassung erreicht wird. Um durch diesen Druck die Membran nicht von dem Sockel abzulösen, kann der Sockel vorzugsweise an seiner zur Gehäuseinnenseite schauenden Stirnseite einen radialen Vorsprung, vorzugsweise einen umlaufenden Absatz besitzen, an dem die Membran aufsitzt. Wird von der Außenseite her dann der Betätigungsknopf auf den Sockel gesetzt und dadurch der Randabschnitt der Membran zusammengedrückt, so fängt der radiale Vorsprung am Sockel den entsprechenden Druck auf die Membran auf. Die Membran wird zwischen dem radialen Absatz des Sockels und dem radial vorspringenden Rand des Betätigungsknopfs zusammengedrückt.

Der vor dem Aufsetzen des Betätigungsknopfs zur Gehäuseaußenseite vorspringende Randabschnitt der Membran kann einen ringförmigen Kragen bilden, der stirnseitig an der Unterseite des Betätigungsknopfs ansteht.

Alternativ kann der Randabschnitt der Membran um den Sockel herum auch eine zum Sokkel koaxiale, daran anschließende Ausnehmung begrenzen, in die der Betätigungsknopf passgenau eingesetzt ist. Um auch hier ein sattes Aufsitzen des Betätigungsknopfs auf der Membran zu erreichen, können die Ausnehmung der Membran und ebenso die Unterseite des Betätigungsknopfs kegelig ausgebildet sein, wobei vorzugsweise die Ausnehmung einen kleineren Kegelwinkel als die damit zusammenwirkende Unterseite des Betätigungsknopfabschnitts besitzt.

Um bei einer großflächigen Membran eine bessere Abstützung der Membran zu erreichen, kann an dem Sockel und/oder an dem mindestens einen elastischen Steg zumindest eine auskragende Membranstütze in Form eines Flügels oder einer dünnen Platte oder dergleichen befestigt, vorzugsweise daran angeformt sein. Die Membran ist dadurch nicht nur durch die Fläche des elastischen Stegs selbst, sondern auch durch die zusätzliche Fläche einer solchen auskragenden Membranstütze abgestützt. Unabhängig von der mechanischen Wirkung kann eine solche auskragende Platte bzw. der entsprechende Flügel an dem Sokkel oder der Membran auch angeformt werden, um eine spezielle optische Wirkung zu erreichen.

Der Sockel kann auch über mehrere elastische Stege mit dem Rand der Gehäuseöffnung verbunden sein. Auch hierdurch wird eine bessere Abstützung der Membran bewirkt.

Zweckmäßigerweise ist die Membran nicht nur mit dem Sockel, der den Betätigungsknopf trägt, stofflich verbunden, sondern auch mit dem Gehäusekorpus. Die Membran wird an den Rand der entsprechenden Gehäuseöffnung im Zweikomponenten-Spritzgussverfahren angespritzt.

Weitere Ziele, Vorteile, Merkmale und Anwendungsmöglichkeiten der vorliegenden Erfindung ergeben sich aus der nachfolgenden Beschreibung bevorzugter Ausführungsbeispiele anhand der Zeichnungen. Dabei bilden alle beschriebenen und/oder bildlich dargestellten Merkmale für sich oder in beliebiger sinnvoller Kombination den Gegenstand der vorliegenden Erfindung, auch unabhängig von ihrer Zusammenfassung in den Ansprüchen oder deren Rückbeziehungen. In den Zeichnungen zeigen:
- Figur 1: einen Schnitt durch den Gehäusekorpus eines Elektrogerätegehäuses entlang der Linie A-A in Figur 2, der einen Ausschnitt des Gehäusekorpus mit einer Öffnung und einem darin angeordneten Sockel zur Befestigung eines Betätigungsknopfs zeigt,
- Figur 2: eine Draufsicht auf den Gehäusekorpus und die darin vorgesehene Öffnung aus Figur 1,
- Figur 3: eine Schnittansicht des Gehäusekorpus ähnlich Figur 1, wobei die Gehäuseöffnung durch eine elastische Membran verschlossen ist und ein Betätigungsknopf vor seiner Befestigung an dem Sockel in der Gehäuseöffnung gezeigt ist,
- Figur 4: einen Schnitt des Gehäusekorpus ähnlich Figur 3, der den Betätigungsknopf im gefügten Zustand zeigt,
- Figur 5: einen Schnitt ähnlich den Figuren 1, 3 und 4 eines Elektrogerätegehäuses nach einer alternativen Ausführung der Erfindung, bei der der Betätigungsknopf mittels einer Sonotrode mit dem in der Membran angeordneten Sockel gefügt wird,
- Figur 6: einen Schnitt ähnlich Figur 3 einer weiteren bevorzugten Ausführung eines Elektrogerätegehäuses, der einen kegeligen Betätigungsknopf vor dem Fügen mit dem in der Membran angeordneten Sockel zeigt,
- Figur 7: einen Schnitt ähnlich Figur 4 einer weiteren bevorzugten Ausführung eines Elektrogerätegehäuses,
- Figur 8: einen Schnitt ähnlich Figur 7 einer weiteren bevorzugten Ausführungsform eines Elektrogerätegehäuses,
- Figur 9: einen Schnitt ähnlich den Figuren 3 und 6 eines Elektrogerätegehäuses nach einer weiteren bevorzugten Ausführung der Erfindung, bei der der Betätigungsknopf vor dem Fügen mit dem in der Membran angeordneten Sockel gezeigt ist und durch Reibschweißen mit dem Sockel gefügt wird,
- Figur 10: einen Schnitt des Elektrogerätegehäuses aus Figur 9, der den Betätigungsknopf im mit dem Sockel gefügten Zustand zeigt,
- Figur 11: einen Schnitt ähnlich den vorhergehenden Figuren einer weiteren bevorzugten Ausführung der Erfindung, bei dem der Betätigungsknopf im Zweikomponenten-Spritzgussverfahren an dem Sockel angespritzt ist,
- Figur 12: einen Schnitt ähnlich den vorhergehenden Figuren einer weiteren bevorzugten Ausführung der Erfindung eines Elektrogerätegehäuses, bei der der Betätigungsknopf materialhomogen mit dem Sockel ausgebildet ist,
- Figur 13: einen Schnitt ähnlich Figur 1 eines Gehäusekorpus eines Elektrogerätegehäuses nach einer bevorzugten Ausführung der Erfindung, bei der zwei Sokkel zur Aufnahme zweier Betätigungsknöpfe in einer Gehäuseöffnung angeordnet sind, wobei der Schnitt entlang der Linie B-B in Figur 14 gemacht ist,
- Figur 14: eine Draufsicht auf den Gehäusekorpus aus Figur 13,
- Figur 15: einen Schnitt ähnlich den Figuren 1 und 13 eines Gehäusekorpus eines Elektrogerätegehäuses, bei dem ein Sockel zur Aufnahme eines Betätigungsknopfs in einer Gehäuseöffnung mittels zweier elastischer Stege am Gehäusekorpus angeformt ist, wobei der Schnitt entlang der Linie C-C in Figur 16 gemacht ist,
- Figur 16: eine Draufsicht auf den Gehäusekorpus aus Figur 15,
- Figur 17: eine Draufsicht ähnlich Figur 16 auf einen Gehäusekorpus nach einer weiteren Ausführung der Erfindung, bei der eine plattenförmige Membranabstützung an dem Sockel angeformt ist, und
- Figur 18: eine Draufsicht ähnlich den Figuren 16 und 17 auf einen Gehäusekorpus nach einer weiteren Ausführung der Erfindung, bei der mehrere Membranabstützungen in Form von Flügeln an Sockel und Steg in der Gehäuseöffnung angeformt sind.

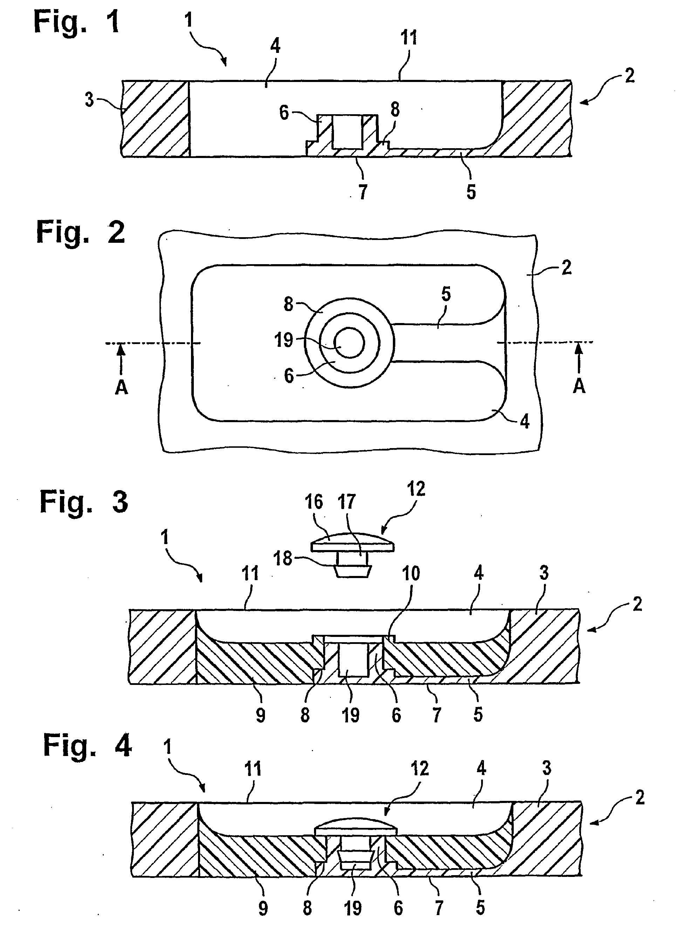

Die Figuren 1 bis 4 zeigen ausschnittsweise das Gehäuse 1 einer elektrischen Zahnbürste oder eines ähnlichen Elektrogerätes mit einem Gehäusekorpus 2 aus einem harten Kunststoff wie beispielsweise Polypropylen oder ABS, in dessen Wandung 3 eine Öffnung 4 ausgebildet ist, die in der gezeichneten Ausführung einen etwa rechteckigen Umriß mit abgerundeten Ecken besitzt. Es versteht sich jedoch, dass die Öffnung 4 auch andere Formen besitzen kann.

Von dem Rand der Öffnung 4 aus ragt ein dünner Steg 5 in die Öffnung 4 hinein, der Teil des Gehäusekorpus 2 ist. Wie Figur 1 zeigt, ist der Steg 5 integral an die Wandung 3 angeformt. Am freien Ende trägt der Steg 5 einen Sockel 6, der etwa mittig zu der Öffnung 4 ausgerichtet ist und in der gezeichneten Ausführung eine etwa zylindrische Kontur besitzt. An seinem der Innenseite 7 zugewandten Ende besitzt der Sockel 6 einen radial vorspringenden Absatz 8 (vgl. Figur 1).

Der Steg 5, der sich parallel zur Ebene der Öffnung 4 erstreckt, liegt etwa am unteren, zur Innenseite 7 hin liegenden Rand der Öffnung 4.

Der Gehäusekorpus 2 einschließlich des Stegs 5 und des Sockels 6 sowie die Öffnung 4 werden im Spritzgießverfahren hergestellt. In einem zweiten Spritzvorgang wird eine Membran 9 in die Öffnung 4 über den Steg 5 und um den Sockel 6 gespritzt. Wie Figur 3 zeigt, weist die Membran 9 eine niedrige Erhöhung 10 in Form eines ringförmig um den Sockel 6 umlaufenden Kragens auf. Die Membran 9 besteht aus einem weichen Kunststoff wie beispielsweise TPE. Dieser weiche Kunststoff verbindet sich beim Spritzgießen stofflich mit dem harten Kunststoff der Wandung 3 des Gehäusekorpus 2 sowie des daran angeformten Stegs 5 und Sockels 6. Die Kunststoffe des Gehäusekorpus 2 einschließlich Steg 5 und Sockel 6 sowie der Membran 9 sind stofflich miteinander verwandt, so dass eine gute Verbindung erreicht wird. Wie Figur 3 zeigt, ist die Dicke der Membran 9 geringer als die Dicke der Wandung 3. Die zur Außenseite 11 gewandte Oberfläche der Membran 9 liegt tiefer als das Niveau der die Öffnung 4 umgebenden Wandung 3 des Gehäusekorpus 2. Der Gehäusekorpus 2 besitzt damit im Bereich der von der Membran 9 verschlossenen Öffnung 4 eine leichte Senke.

An dem Sockel 6 wird ein Betätigungsknopf 12 befestigt, der etwa pilzförmig ausgebildet ist. Der Betätigungsknopf 12 umfasst einen Kopf 16 und einen schaftförmigen Hals 17, an dem eine scharfkantige, radial vorspringende Rippe 18 angeformt ist. Der Betätigungsknopf 12 kann aus Metall wie Stahl, Edelstahl, Aluminium und dergleichen oder auch einem sehr harten Kunststoff oder auch Keramik oder Glas bestehen. Die Oberfläche kann durch Galvanisieren, anodische Oxydation, Ätzen, Beschichten, Färben, Schleifen oder Strahlen und dergleichen veredelt sein. Anstelle der einen Rippe 18 können auch mehrere Rippen axial hintereinander an dem schaftförmigen Hals 17 angeordnet sein.

Wie die Figuren 3 und 4 zeigen, wird der Betätigungsknopf 12 in ein Sackloch 19, das in dem Sockel 6 ausgebildet ist, kalt eingepreßt, wobei sich die Rippe 18 in der Wand des Sacklochs 19 verankert. Durch das Aufsetzen des Betätigungsknopfs 12 auf den Sockel 6 wird die Erhöhung 10 der Membran 9 zwischen dem Absatz 8 des Sockels 6 und dem Kopf 16 des Betätigungsknopfs 12 zusammengedrückt. Die dadurch entstehende Pressung verhindert das Eindringen von Schmutz zwischen der Membran 9 und dem Kopf 16 des Betätigungsknopfs 12.

Um das Einpressen des Halses 17 in das Sackloch 19 zu erleichtern, kann der Betätigungsknopf 12 vor dem Einpressen erwärmt werden. Besteht der Betätigungsknopf 12 aus Metall, so kann er durch Induktion in einem hochfrequenten elektrischen Feld erwärmt werden.

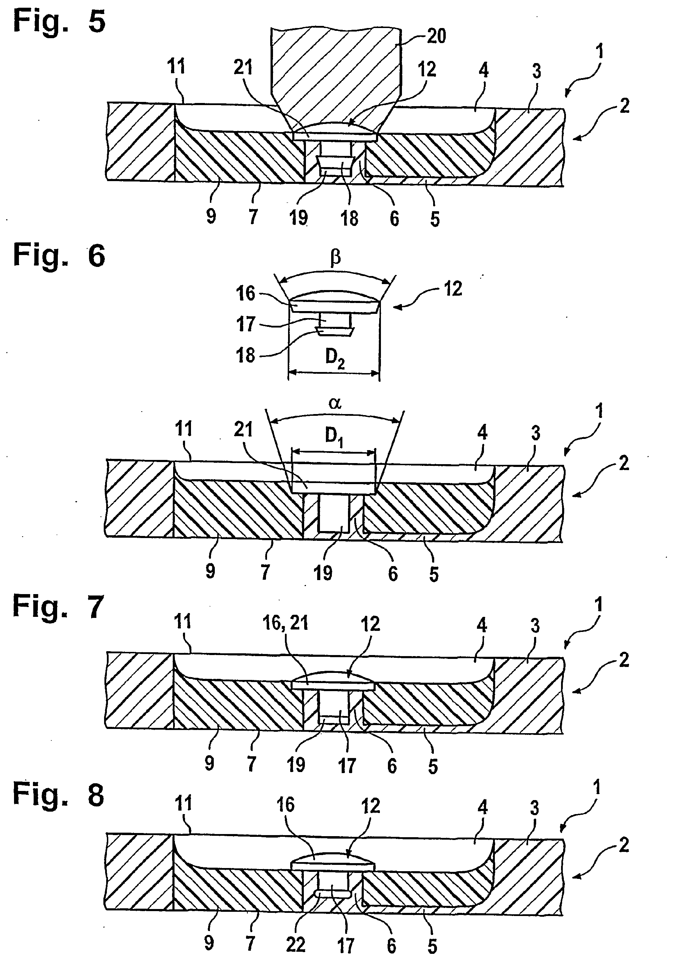

Alternativ kann der Betätigungsknopf 12 auch mittels einer Sonotrode in Form eines Stößels 20, der mit Ultraschallfrequenz schwingt, in das Sackloch 19 des Sockels 6 eingepresst werden, wie dies Figur 5 zeigt. Die Ultraschallschwingung wird auf den Betätigungsknopf 12 übertragen, wobei sich durch Reibung der harte Kunststoff des Sockels 6 an der Kontaktstelle mit dem Betätigungsknopf 12 erwärmt. Dies erleichtert das Eindringen des Halses 17 und der Rippe 18 in das Sackloch 19 sowie das Fließen des Kunststoffs in den Ringraum zwischen Kopf 16, Hals 17 und Rippe 18. Nach Erkalten ist der Betätigungsknopf 12 fest mit dem Sockel 6 verbunden. Wie Figur 5 zeigt, besitzt die Membran bei dieser Ausführung keine stegförmige Erhöhung um den Sockel 6 herum, sondern eine in der Kontur dem Kopf 16 des Betätigungsknopfs 12 entsprechende Ausnehmung 21, in der der Kopf 16 nach dem Einfügen in den Sockel 6 passgenau sitzt.

Bei der Ausführung nach Figur 5 besitzen sowohl der Kopf 16 des Betätigungsknopfs 12 als auch die Ausnehmung 21 in der Membran 9 eine zylindrische Kontur. Alternativ hierzu kann, wie Figur 6 zeigt, die Ausnehmung 21 in der Membran 9, die axial an den Sockel 6 zur Aussenseite hin anschließt, konisch ausgebildet sein und sich zur Außenseite 11 hin unter einem Winkel α erweitern. Der Kopf 16 des Betätigungsknopfs 12 ist kegelig ausgebildet. Er verjüngt sich zum Hals 17 hin unter dem Winkel β, der vorzugsweise größer ist als der Winkel α der Ausnehmung 21. Zudem ist auch der größte Durchmesser D₂ des Kopfes 16 etwas größer als der entsprechende Durchmesser D₁ der Ausnehmung 21. Nach dem Einpressen des Betätigungsknopfs 12 steht der weiche Kunststoff der Membran 9 in der Nähe des Kopfes 16 unter Spannung, die das Eindringen von Schmutz in die Ausnehmung 21 verhindert.

Alternativ zu den vorher beschriebenen Ausführungen kann der Hals 17 des Betätigungsknopfs 12 auch glatt, d.h. frei von Vorsprüngen ausgebildet sein. Wie Figur 7 zeigt, sitzt der Hals 17 passgenau in dem Sackloch 19 des Sockels 6 und ist darin festgeklebt. Die Ausnehmung 21 der Membran passt zum Kopf 16 des Betätigungsknopfs 12.

Bei einer weiteren Variante des Betätigungsknopfs 12, die Figur 8 zeigt, trägt dessen Hals 17 einen ringförmigen Wulst 22 anstelle der zuvor beschriebenen scharfkantigen Rippe 18. Der Betätigungsknopf 12 ist dabei in dem Sockel 6 eingegossen. Der Betätigungsknopf 12 wird in die Spritzform eingelegt, so dass der Hals 17 und der Wulst 22 beim Spritzgießen des Gehäusekorpus 2 mit hartem Kunststoff umspritzt werden. Anschließend wird im zweiten Gussschritt die Membran 9 aus weichem Kunststoff im Zweikomponenten-Spritzverfahren angeformt.

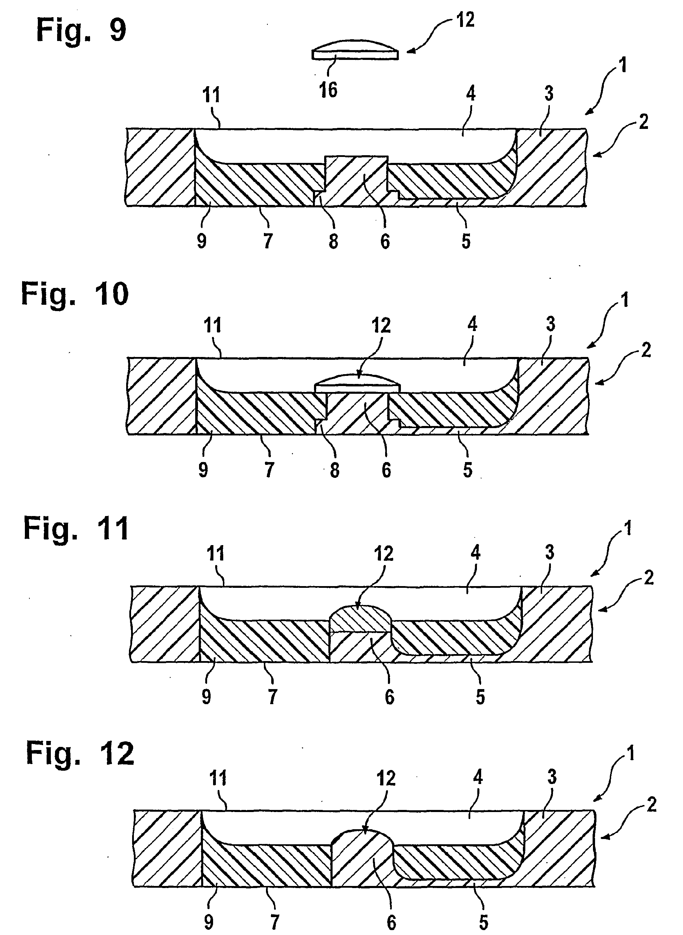

Der Betätigungsknopf 12 muss nicht zwangsweise einen an den Kopf 16 anschließenden Hals 17 aufweisen. Die Figuren 9 und 10 zeigen eine Ausführung, bei der der Betätigungsknopf 12 lediglich aus dem Kopf 16 besteht, wobei dessen Unterseite vorzugsweise eben ausgebildet ist. Der Sockel 6 ist gegenüber der Membran 9 etwas erhaben ausgebildet, so dass der Betätigungsknopf 12 durch Schweißen, beispielsweise Reibschweißen, mit dem Sockel 6 verbunden werden kann. Vorzugsweise bestehen der Sockel 6 und der Betätigungsknopf 12 hierbei aus demselben Kunststoff oder aus miteinander verwandten Kunststoffen, wobei beide Teile unterschiedlich gefärbt sein können. Wenn der Betätigungsknopf 12 aus ABS besteht, kann an den Sichtflächen vor dem Schweißen durch Galvanisieren eine dekorative Metallschicht aufgebracht werden. Wie ein Vergleich der Figuren 9 und 10 zeigt, wird der Sockel 6 beim Reibschweißen mit dem Betätigungsknopf 12 ein wenig abgetragen, so dass die Unterseite des Betätigungsknopfs 12 nach dem Fügen bündig auf der Oberseite der Membran 9 aufliegt.

Wie Figur 11 zeigt, kann der Betätigungsknopf 12 auch im Zweikomponenten-Spritzverfahren an dem Sockel 6 befestigt werden. Der Betätigungsknopf 12 besteht dabei aus hartem Kunststoff, der vorzugsweise mit dem Kunststoff des Sockels 6 zumindest verwandt ist, um eine gute Verbindung beim Anspritzen zu erreichen. Durch das separate Anspritzen des Betätigungsknopfs 12 kann diesem eine andere Farbe als dem Gehäusekorpus 2 gegeben werden, so dass eine gute Erkennbarkeit erreicht wird. Die Membran 9 wird in einem dritten Spritzvorgang angeformt.

Die Ausführung nach Figur 12 zeigt einen Betätigungsknopf 12, der von dem Sockel 6 selbst gebildet wird. Der Betätigungsknopf 12 wird dabei als Fortsetzung des Sockels 6 beim Spritzgießen des Gehäusekorpus 2 hergestellt. Die Membran 9 wird um den Betätigungsknopf 12 herum im zweiten Spritzvorgang angeformt. Bei dieser Ausführung haben der Gehäusekorpus 2 und der Betätigungsknopf 12 die gleiche Farbe. Dennoch kann die Erkennbarkeit des Betätigungsknopfs 12 sehr gut sein, wenn die Membran 9 eine andere Farbe hat. Diese Ausführung zeichnet sich durch eine besonders billige Herstellbarkeit aus.

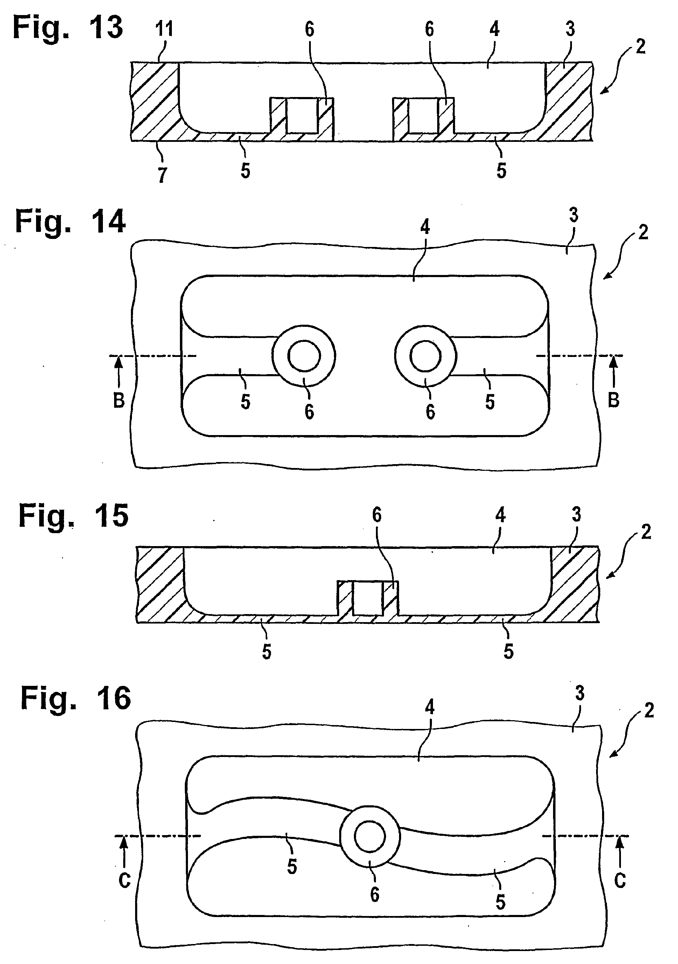

Wie die Figuren 13 und 14 zeigen, ist es selbstverständlich möglich, in der Öffnung 4 des Gehäusekorpus 2 zwei Sockel 6 anzuordnen, so dass zwei Betätigungsknöpfe angebracht werden können. Hierdurch können mehrere unter der Membran liegende Funktionselemente betätigt werden. Es ist auch möglich, mit dem einen Betätigungsknopf einen darunter liegenden Schalter einzuschalten und mit dem anderen Betätigungsknopf denselben Schalter auszuschalten. Wie die Figuren 13 und 14 zeigen, sind die beiden Sockel 6 jeweils an einem separaten Steg 5 angeordnet, die sich beide jeweils von der Wandung 3 des Gehäusekorpus 2 in die Öffnung 4 hinein erstrecken. Hierdurch ist, vom Einfluss der Membran 9 abgesehen, eine unabhängige Betätigung der auf den beiden Sockeln 6 befestigten Betätigungsknöpfe möglich.

Nach einer anderen Ausführungsform der Erfindung ist vorgesehen, dass der Sockel 6 in der Öffnung 4 von zwei Stegen 5 getragen wird. Wie die Figuren 15 und 16 zeigen, sind die beiden flachen Stege, die in einer gemeinsamen Ebene parallel zur Ebene der Öffnung 4 angeordnet sind, bogen- oder wellenförmig, um den Biegewiderstand quer zu ihrer Ebene gering zu halten. Sie erstrecken sich zu gegenüberliegenden Rändern der Öffnung 4 hin. Nach Umspritzen der Stege 5 und des Sockels 6 mit einer Membran, kann der Sockel 6 in der zuvor beschriebenen Weise einen Betätigungsknopf aufnehmen.

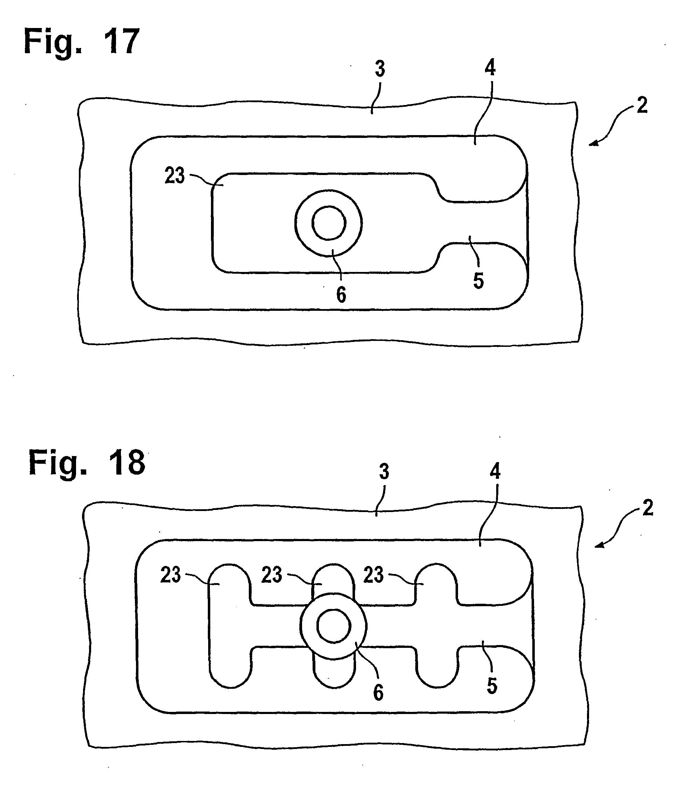

Insbesondere aus ästhetischen Gründen kann eine großflächige Membran 9 in dem Gehäusekorpus 2 gefordert werden. Hierbei besteht jedoch die Gefahr, dass sich die Membran 9 verformt und beispielsweise Beulen oder Falten bildet. Um hier Abhilfe zu schaffen, kann an dem Steg 5 und/oder dem Sockel 6 eine parallel zur Ebene der Öffnung 4 auskragende Membranstütze 23 angeformt sein. Wie Figur 17 zeigt, kann eine Membranstütze 23 in Form einer dünnen Platte an dem Sockel 6 und dem Steg 5 befestigt sein, wobei die Platte etwa konzentrisch zu der Öffnung 4 angeordnet ist. Gemäß der Ausführung nach Figur 18 können auch mehrere Membranstützen 23 in Form von Fingern bzw. Flügeln vorgesehen sein, die sich in der Ebene der Öffnung 4 von dem Sockel 6 und quer von dem Steg 5 weg erstrekken. Nach Umspritzen der Stege 5, des Sockels 6 sowie der Membranstützen 23 mit einer Membran aus Weichkunststoff kann der Sockel 6 in der zuvor beschriebenen Weise einen Betätigungsknopf aufnehmen.

In den zuvor beschriebenen Ausführungen sind der Betätigungsknopf 12 einschließlich Kopf 16, Hals 17 und Rippe 18 bzw. Wulst 22 im Querschnitt rund ausgebildet. Es kann jedoch auch ein unrunder Querschnitt vorgesehen werden, um den Betätigungsknopf 12 drehfest im Sockel 6 zu verankern. Hierbei kann an dem Betätigungsknopf 12 ein gerichtetes Symbol wie beispielsweise ein Pfeil vorgesehen sein, der die Druckrichtung und/oder die Wirkung der Betätigung des Betätigungsknopfs 12 angibt.

Bei den zuvor beschriebenen Ausführungen sind die Wandung 3 des Gehäusekorpus 2 sowie die Membran 9 im wesentlichen eben ausgebildet. Es versteht sich jedoch, dass alternativ hierzu auch gekrümmte Wandungen oder Membranen vorgesehen sein können.

## Patentansprüche

1. Gerätegehäuse, insbesondere Elektrogerätegehäuse, mit einem Gehäusekorpus (2) aus Hartkunststoff, in dem eine Öffnung (4) zur Betätigung eines Schalters oder dergleichen im Inneren des Gehäusekorpus (2) vorgesehen ist, wobei die Öffnung (4) mit einer Membran (9) aus Weichkunststoff verschlossen ist und ein Betätigungsknopf (12) zur Betätigung des Schalters auf der bzw. in der Membran (9) vorgesehen ist, **dadurch gekennzeichnet, dass** der Betätigungsknopf (12) an einem Sockel (6) aus Hartkunststoff befestigt ist, der stofflich mit der Membran (9) verbunden ist.

2. Gerätegehäuse nach dem vorhergehenden Anspruch, wobei der Sockel (6) über zumindest einen elastischen Steg (5) mit dem Gehäusekorpus (2) verbunden, insbesondere integral an dem Gehäusekorpus (2) angeformt ist.

3. Gerätegehäuse nach einem der vorhergehenden Ansprüche, wobei der Sockel (6) frei von Durchgangsausnehmungen ausgebildet und/oder vom Betätigungsknopf (12) undurchdrungen ist.

4. Gerätegehäuse nach einem der vorhergehenden Ansprüche, wobei an einer zur Gerätegehäuseaußenseite (11) schauenden Stirnseite des Sockels (6) eine Ausnehmung (21) in der Membran (9) vorgesehen ist, wobei vorzugsweise der Sockel (6) die Membran (9) von deren Außenseite (11) zu deren Innenseite (7) durchdringt.

5. Gerätegehäuse nach einem der vorhergehenden Ansprüche, wobei der zumindest eine elastische Steg (5) auf einer Innenseite (7) der Membran (9) liegt.

6. Gerätegehäuse nach einem der vorhergehenden Ansprüche, wobei der Betätigungsknopf (12) über die Membran (9) zur Gehäuseaußenseite (11) hin vorspringt.

7. Gerätegehäuse nach einem der vorhergehenden Ansprüche, wobei der Betätigungsknopf (12) und der Sockel (6) miteinander gefügt sind.

8. Gerätegehäuse nach einem der vorhergehenden Ansprüche, wobei der Sockel (6) ein Sackloch (19) besitzt, in dem der Betätigungsknopf (12) mit einem schaftförmigen Hals (17) aufgenommen ist, wobei vorzugsweise an dem Hals (17) mindestens eine radiale Rippe (18) und/oder mindestens ein Wulst (22) vorgesehen ist.

9. Gerätegehäuse nach einem der vorhergehenden Ansprüche, wobei der Betätigungsknopf (12) materialhomogen und einstückig am Sockel (6) angeformt ist.

10. Gerätegehäuse nach einem der vorhergehenden Ansprüche, wobei die Membran (9) einen den Sockel (6) umschließenden, über den Sockel (6) zur Gehäuseaußenseite (11) vorspringenden Randabschnitt aufweist, der passgenau oder unter einer Presspassung an einem Randabschnitt des Betätigungsknopfs (12) anliegt.

11. Gerätegehäuse nach dem vorhergehenden Anspruch, wobei der Randabschnitt der Membran (9) eine ringförmige Erhöhung (10) bildet, der stirnseitig an einer Unterseite des Betätigungsknopfs (12) ansteht.

12. Gerätegehäuse nach einem der vorhergehenden Ansprüche, wobei der Randabschnitt eine am Sockel (6) axial anschließende Ausnehmung (21) begrenzt, in die ein Abschnitt des Betätigungsknopfs (12) eingesetzt ist, wobei vorzugsweise die Ausnehmung (21) und der genannte Abschnitt des Betätigungsknopfs (12) konisch ausgebildet sind und/oder die Ausnehmung (21) einen kleineren Konuswinkel als der damit zusammenwirkende Abschnitt des Betätigungsknopfs (12) aufweist.

13. Gerätegehäuse nach einem der vorhergehenden Ansprüche, wobei der Sockel (6) an der Innenseite (7) einen radialen Vorsprung, vorzugsweise einen umlaufenden Absatz (8) aufweist.

14. Gerätegehäuse nach einem der vorhergehenden Ansprüche, wobei der Gehäusekorpus (2) aus Hartkunststoff besteht und mit der aus Weichkunststoff bestehenden Membran (9) stofflich verbunden, insbesondere im Zweikomponenten-Spritzgussverfahren spritzgegossen ist.

15. Gerätegehäuse nach einem der vorhergehenden Ansprüche, wobei an dem Sockel (6) und/oder dem mindestens einen elastischen Steg (5) zumindest eine auskragende Membranstütze (23) befestigt, vorzugsweise integral angeformt ist.

16. Gerätegehäuse nach einem der vorhergehenden Ansprüche, **dadurch gekennzeichnet, dass** der Steg (5) bogen- oder wellenförmig ist.

## Claims

1. An appliance housing, in particular an electrical appliance housing, with a housing body (2) made from hard plastic, in which provision is made for an aperture (4) to actuate a switch or the like in the interior of the housing body (2), said aperture (4) being sealed by means of a membrane (9) of soft plastic, and further provision is made for an actuating button (12) on or in the membrane (9) for actuating the switch, **characterized in that** the actuating button (12) is fastened to a base (6) of hard plastics material that is bonded to the material of the membrane (9).

2. The appliance housing according to the preceding claim wherein the base (6) is connected by means of at least one elastic bar (5) to the housing body (2), being in particular molded integrally with the housing body (2).

3. The appliance housing according to any one of the preceding claims wherein the base (6) is constructed free of through-holes and/or is not penetrated by the actuating button (12).

4. The appliance housing according to any one of the preceding claims wherein on an end face of the base (6) facing the outer side (11) of the appliance housing provision is made in the membrane (9) for a recess (21), with the base (6) preferably penetrating the membrane (9) from its outer side (11) to its inner side (7).

5. The appliance housing according to any one of the preceding claims wherein the at least one elastic bar (5) lies on an inner side (7) of the membrane (9).

6. The appliance housing according to any one of the preceding claims wherein the actuating button (12) protrudes beyond the membrane (9) towards the housing outer side (11).

7. The appliance housing according to any one of the preceding claims wherein the actuating button (12) and the base (6) are joined together.

8. The appliance housing according to any one of the preceding claims wherein the base (6) has a blind-end bore (19) receiving a shaft-shaped neck (17) of the actuating button (12), said neck (17) having preferably at least one radial rib (18) and/or at least one bead (22).

9. The appliance housing according to any one of the preceding claims wherein the actuating button (12) exhibits material homogeneity with the base (6) and is molded onto the base in one integral piece.

10. The appliance housing according to any one of the preceding claims wherein the membrane (9) has an edge section that encloses the base (6) and projects beyond the base (6) towards the outer side (11) of the housing and which abuts with a precise fit or with a press-fit against an edge section of the actuating button (12).

11. The appliance housing according to the preceding claim wherein the edge section of the membrane (9) forms an annular elevation (10) which with its end face engages an underside of the actuating button (12).

12. The appliance housing according to any one of the preceding claims wherein the edge section forms a boundary for a recess (21) that adjoins the base (6) axially and into which a section of the actuating button (12) is inserted, said recess (21) and said section of the actuating button (12) being preferably shaped in a conical configuration and/or said recess (21) having a smaller cone angle than the cooperating section of the actuating button (12).

13. The appliance housing according to any one of the preceding claims wherein the base (6) has on the inner side (7) a radial projection, preferably a circumferential shoulder (8).

14. The appliance housing according to any one of the preceding claims wherein the housing body (2) is made of hard plastics material which is bonded to the soft plastics material of the membrane (9), in particular injection molded by the two-component injection-molding method.

15. The appliance housing according to any one of the preceding claims wherein at least one protruding membrane support member (23) is fastened, preferably integrally molded onto the base (6) and/or the at least one elastic bar (5).

16. The appliance housing according to any one of the preceding claims wherein said bar (5) is shaped in an arcuate or undulating configuration.

## Revendications

1. Boîtier d'appareil, notamment boîtier d'appareil électrique, avec un corps de boîtier (2) en matière plastique dure, dans lequel est prévu un orifice (4) pour la manoeuvre d'un interrupteur ou similaire à l'intérieur du corps de boîtier (2), l'orifice (4) étant fermé par une membrane (9) en matière plastique souple et un bouton de manoeuvre (12) pour la manoeuvre de l'interrupteur étant prévu sur ou dans la membrane (9), **caractérisé en ce que** le bouton de manoeuvre (12) est fixé sur un socle (6) en matière plastique dure qui est relié par matière avec la membrane (9).

2. Boîtier d'appareil selon la revendication précédente, le socle (6) étant relié par l'intermédiaire d'au moins une barrette élastique (5) avec le corps du boîtier (2), notamment rapporté de façon intégrale sur le corps du boîtier (2).

3. Boîtier d'appareil selon l'une quelconque des revendications précédentes, le socle (6) étant réalisé libre d'évidements de passage et/ou n'étant pas traversé par le bouton de manoeuvre (12).

4. Boîtier d'appareil selon l'une quelconque des revendications précédentes, sur une face frontale du socle (6) montrant vers la face extérieure du boîtier d'appareil (11) un évidement (21) étant prévu dans la membrane (9), le socle (6) traversant de préférence la membrane (9) de sa face extérieure (11) vers sa face intérieure (7).

5. Boîtier d'appareil selon l'une quelconque des revendications précédentes, la au moins une barrette élastique (5) se situant sur la face intérieure (7) de la membrane (9).

6. Boîtier d'appareil selon l'une quelconque des revendications précédentes, le bouton de manoeuvre (12) saillant par-dessus la membrane (9) vers la face extérieure du boîtier (11).

7. Boîtier d'appareil selon l'une quelconque des revendications précédentes, le bouton de manoeuvre (12) et le socle (6) étant assemblés l'un à l'autre.

8. Boîtier d'appareil selon l'une quelconque des revendications précédentes, le socle (6) comportant un trou borgne (19) dans lequel le bouton de manoeuvre (12) est logé par un col en forme de tige (17), alors que de préférence sur le col (17), il est prévu au moins une nervure radiale (18) et/ou au moins un bourrelet (22).

9. Boîtier d'appareil selon l'une quelconque des revendications précédentes, le bouton de manoeuvre (12) étant rapporté par matière homogène et en monobloc sur le socle (6).

10. Boîtier d'appareil selon l'une quelconque des revendications précédentes, la membrane (9) comportant une section marginale entourant le socle (6), saillant par dessus le socle (6) vers la face extérieure du boîtier (11), qui s'applique en étant précisément ajustée ou par ajustage serré sur une section marginale du bouton de manoeuvre (12).

11. Boîtier d'appareil selon la revendication précédente, la section marginale de la membrane (9) formant une surélévation annulaire (10) qui affleure côté frontal une face inférieure du bouton de manoeuvre (12).

12. Boîtier d'appareil selon l'une quelconque des revendications précédentes, la section marginale délimitant un évidement (21) se raccordant en direction axiale sur le socle (6), dans lequel est insérée une partie du bouton de manoeuvre (12), l'évidement (21) et la partie citée du bouton de manoeuvre (12) étant de préférence réalisés sous forme conique et/ou l'évidement (21) présentant un angle de conicité inférieur à celui de la partie du bouton de manoeuvre (12) coopérant avec lui.

13. Boîtier d'appareil selon l'une quelconque des revendications précédentes, le socle (6) comportant sur la face intérieure (7) une saillie radiale, de préférence un embout périphérique (8).

14. Boîtier d'appareil selon l'une quelconque des revendications précédentes, le corps de l'appareil (2) étant en matière plastique dure et étant relié par matière avec la membrane (9) en matière plastique souple, étant notamment moulé par injection par procédé de moulage par injection de bi-composants.

15. Boîtier d'appareil selon l'une quelconque des revendications précédentes, au moins un support de membrane (23) débordant étant fixé, de préférence intégralement rapporté sur le socle (6) et/ou sur la au moins une barrette élastique (5).

16. Boîtier d'appareil selon l'une quelconque des revendications précédentes, **caractérisé en ce que** la barrette (5) est arquée ou ondulée.
